# EUROPÄISCHE PATENTSCHRIFT

(11) **EP 2 097 342 B1**
(45) Veröffentlichungstag und Bekanntmachung des Hinweises auf die Patenterteilung: **22.03.2023**
(21) Anmeldenummer: 07816275.7
(22) Anmeldetag: 27.11.2007
(51) Int. Cl.: B65H 29/00, H01L 21/67, H01L 21/677

(54) **TRANSFERVORRICHTUNG FÜR EINE ÜBERKOPF-TRANSPORTANLAGE**
TRANSFER DEVICE FOR AN OVERHEAD CONVEYING SYSTEM
DISPOSITIF DE TRANSFERT POUR UNE INSTALLATION DE TRANSPORT AERIEN

(30) Priorität: 27.11.2006 CH 19092006
(43) Veröffentlichungstag der Anmeldung: 09.09.2009
(73) Patentinhaber: Brooks CCS RS AG, 8274 Tägerwilen (CH)
(72) Erfinder: BLATTNER, Jakob, 8272 Ermatingen (CH); FEDERICI, Rodolfo, 8572 Berg (CH)
(74) Vertreter: Klein, Friedrich Jürgen
(86) Internationale Anmeldenummer: PCT/CH2007/000592
(87) Internationale Veröffentlichungsnummer: WO 2008/064507

(56) Entgegenhaltungen:
- EP-A2- 1 394 840
- WO-A-03/087436
- WO-A-2006/046580
- WO-A1-00/02803
- WO-A1-2005/006407
- WO-A2-01/63651
- US-A- 5 826 129
- US-A1- 2004 234 360
- H. RITZMANN: "Single Wafer Management Systems and Bare Wafer Storage as Key to Increased Yield and Productivity" ADVANCED SEMICONDUCTOR MANUFACTURING CONFERENCE AND WORKSHOP, 2005 IEEE/SEMI MUNICH, GERMANY 11-12 APRIL 2005, PISCATAWAY, NJ, USA,IEEE, 11. April 2005 (2005-04-11), Seiten 91-95, XP002371536 ISBN: 0-7803-8997-2

## Beschreibung

Die Erfindung betrifft eine Transfervorrichtung für Substrate aus dem Bereich der Fertigung von elektronischen Bauteilen oder Displays, die zur Zuführung von Substraten zu einer Prozessanlage vorgesehen ist, wobei die Transfervorrichtung eine erste Ein-/Ausgabeschnittstelle zu einer Überkopf-Transportanlage für Substrat-Transportboxen, sowie eine zweite Ein-/Ausgabeschnittstelle zur Prozessanlage aufweist, wobei die erste Schnittstelle in Bezug auf eine vertikale Richtung oberhalb der zweiten Schnittstelle angeordnet ist. Die Erfindung betrifft zudem ein Verfahren gemäss dem Oberbegriff von Patentanspruch 12.

In weitestgehend automatisierten Fabrikationsanlagen für elektronische Bauteile, wie beispielsweise Prozessoren, Speicherbausteine, Bildschirmpanels und dergleichen, werden die hierfür benötigten bzw. zu bearbeitenden Substrate in Transportboxen zwischen den Prozessanlagen in denen sie bearbeitet oder zwischengelagert werden, mittels einer Transportanlage hin und her transportiert. Die Transportanlagen sind vielfach als hochgelagerte Transportanlagen, sogenannte Overhead Hoist Transport (OHT), ausgebildet. Die Substrate werden hierzu in ihren Transportboxen und zusammen mit diesen durch eine gattungsgemäße Beschickungsvorrichtung, wie sie beispielsweise in der WO 2005006408 A1 oder auch die WO 2004023530 A2 beschrieben sind, entgegengenommen und an der ersten Ein-/Ausgabeschnittstelle eingeführt. Durch eine im wesentlichen vertikale Transportbewegung der Transportboxen innerhalb der Beschickungs- bzw. Transfervorrichtung können die Transportboxen dann zur zweiten Ein-/Ausgabeschnittstelle überführt werden, an der sie von der Transfervorrichtung an eine Anlage übergeben werden, in der die Substrate bearbeitet oder anderweitig benötigt werden. Auf umgekehrtem Weg können die leeren oder mit Substraten gefüllten Transportboxen von der jeweiligen Anlage wieder automatisiert zur Transportanlage gebracht werden.

Aus der WO 2006/046580 A1 sind mehrere Bearbeitungsvorrichtungen bekannt, die zur Bearbeitung von Substraten im Zusammenhang mit der Fertigung von elektronischen Bauteilen vorgesehen sind. Eine Zu- und Ausfuhr von Substraten in bzw- aus einer jeweiligen Bearbeitungsvorrichtung erfolgt ausschließlich über eine verschließbare Öffnung eines Gehäuses der Bearbeitungsvorrichtung. Eine Transportvorrichtung dieser Anlage hat einen horizontalen Verfahrweg, der in das Gehäuse einer Transfervorrichtung mündet. Die angelieferten Substrate können dann zu einem Ladeplatz angehoben werden, wo sie anschließend durch die eine Öffnung in die Bearbeitungsvorrichtung mittels einer Handhabungseinrichtung der Bearbeitungsvorrichtung selbst, in die Bearbeitungsvorrichtung eingeführt werden. Hierzu werden die Substrate zunächst der Transportvorrichtung entnommen und mittels eines Roboters in ein Speichermittel eingeführt. Das Speichermittel kann dann anschließend vor die Öffnung gebracht werden, wo die Handhabungseinrichtung der Bearbeitungsvorrichtung die Substrate vom Ladeplatz aus in die Bearbeitungsvorrichtung aufnimmt. Der Ladeplatz befindet sich etwa auf Hüfthöhe einer Bedienperson.

Aus der EP 1 394 840 A2 geht eine Lagereinrichtung hervor, die zur Aufnahme von in Transportbehältern angeordneten Substraten vorgesehen ist, wobei die Transportbehälter mittels eines OHTs zur Lagereinrichtung gelangen können. Die Lagereinrichtung ist mit mehreren in Spalten angeordneten Lagerplätzen versehen. Jeder dieser Lagerplätze weist einen separaten Transportbehalteröffner auf. An derartigen Transfervorrichtungen kann ihre geringe Flexibilität in Bezug auf Reaktionsmöglichkeiten bei geänderten Bearbeitungsreihenfolgen der Substrate als nachteilig angesehen werden.

Der Erfindung liegt deshalb die Aufgabe zugrunde, eine Möglichkeit zur automatisierten Überführung von Substraten zur Verfügung zu stellen, die im Zusammenhang mit einer verketteten Produktionsanlage für den Transport von Substraten in Transportboxen eine größere Flexibilität bei der Reihenfolge der Zuführung der angelieferten Substrate zu Prozessanlagen ermöglicht.

Diese Aufgabe wird bei einer Transfervorrichtung der eingangs genannten Art erfindungsgemäß durch den Gegenstand von Anspruch 1 gelöst. Dieser enthält eine in der Transfervorrichtung angeordnete Handhabungseinrichtung, mit der die Substrate aus den Transportboxen entnehmbar sind und frei von Transportboxen in die Transfervorrichtung einführbar sind, sowie Mittel, mit denen die Substrate durch die in der Transfervorrichtung angeordnete Handhabungseinrichtung frei von Transportboxen von der einen zur anderen Ein-/Ausgabeschnittstelle transportierbar sind. Der Erfindung liegt somit der Gedanke zugrunde, die Substrate spätestens innerhalb der Transfervorrichtung aus den Transportboxen zu entnehmen, so dass die Substrate innerhalb der Transfervorrichtung auch zu anderen Zwecken als der blossen Ein- und Ausführung an den Schnittstellen offen gehandhabt werden können, insbesondere auch in einer Speichereinrichtung offen zwischengelagert werden können.

Im Zusammenhang mit der vorliegenden Erfindung soll deshalb "frei von Transportboxen" so verstanden werden, dass die Substrate spätestens unmittelbar hinter der schleusenartigen ersten Ein-/Ausgabeschnittstelle zur Überkopf-Transportanlage im Gehäuse der Transfervorrichtung aus einem Magazin der jeweiligen Transportbox entnommen und ab hier innerhalb der Transfervorrichtung ohne jeden Bestandteil einer Transportbox gehandhabt werden. Ferner schliesst dies mit ein, dass höchstens Bestandteile der Transportboxen kurzfristig zur Entnahme von Substraten unmittelbar hinter der genannten ersten Ein-/Ausgabesschnittstelle in das Gehäuse eingeführt werden, um anschliessend durch die gleiche erste Ein-/Ausgabeschnittstelle wieder ausgeführt zu werden. In einer erfindungsgemäßen Transfervorrichtung sollen jedoch keine Transportboxen gespeichert oder durchgeführt werden.

Diese Maßnahmen eröffnen insbesondere die Möglichkeit, die Substrate innerhalb der Transfervorrichtung mit einer Handhabungseinrichtung durch eine geeignete Manipulation in eine Reihenfolge und/oder Orientierung zu bringen, wie sie für die nachfolgende Bearbeitung in der angeschlossenen Prozessanlage erforderlich ist und wie es sich möglicherweise erst kurzfristig ergibt. Mit einer erfindungsgemäßen Transfervorrichtung kann somit sehr schnell und vor allem flexibel auf geänderte Anforderungen reagiert werden. Es ist hierzu, nicht wie bisher, ein zeitraubender Abtransport der Substrate zu einer entfernt angeordneten Anlage erforderlich, in der erst ein neuer Substratstapel erstellt werden kann. Die Transfervorrichtung eignet sich außer für Wafer auch für alle anderen Substrate, die im Bereich der Fertigung von Elektronikbauteilen oder -geräten benötigt werden, insbesondere auch für Reticles und Bildschirmpanels.

Die erfindungsgemäße Maßnahme ist die Voraussetzung dafür, eine Transfervorrichtung zur Anbindung an eine Überkopf-Transportanlage erstmals mit einer Intelligenz auszustatten, durch die mehr als die bisherige bloße Bewegung der Substrate von der oberen zur unteren Schnittstelle und umgekehrt möglich ist. Da eine erfindungsgemäße Transfervorrichtung die Lücke zwischen der Übergabe-/Aufnahmeposition für Transportboxen an der Überkopf-Transportanlage und der Ein-/Ausgabeschnittstelle einer Prozeßanlage schließt und in dieser Lücke angeordnet werden soll, können erfindungsgemäße Transfervorrichtungen ohne großen Aufwand in bereits bestehende Fabrikationsanlagen integriert werden. In überraschend einfacher und dennoch sehr vorteilhafter Weise kann der bisher kaum genutzte Bereich zwischen der Übergabe-/Aufnahmeposition und der Ein-/Ausgabeschnittstelle einer Prozeßanlage mit einer deutlichen größeren Funktionalität zur logistischen Aufbereitung der Substrate bzw. der mit ihnen gebildeten Stapel versehen werden. Dies führt insbesondere zu einer erheblichen Verkürzung der Lagerzeiten - und damit zu einer Verkürzung der Durchlaufzeiten - der Substrate.

Es ist hierbei bevorzugt, wenn die erfindungsgemässe Transfervorrichtung eine erste Ein-/Ausgabeschnittstelle aufweist, die sich - in vertikaler Richtung - möglichst nahe an der Überkopf-Transportanlage befindet. Hierdurch wird einerseits der Transportweg zwischen der Transfervorrichtung und der Überkopf-Transportanlage möglichst kurz und die Übergabe dadurch mit wenig technischem Aufwand möglich. Andererseits wird hierdurch auch trotz einer kleinen Stellfläche der Transfervorrichtung ein großes Volumen innerhalb der Transfervorrichtung möglich, das eine Aufnahme von verschiedenen Funktionseinheiten zuläßt, beispielsweise eine Speichereinrichtung mit einer besonders grossen Aufnahmekapazität für Substrate.

Da es mit der erfindungsgemässen Transfervorrichtung möglich ist, jedes von der Überkopf-Transportanlage bereits angelieferte Substrat auf Anforderung sofort der jeweiligen Prozessanlage zur Verfügung zu stellen, können insbesondere Verweilzeiten von Substraten und Transportboxen außerhalb ihres Bearbeitungsprozesses vor der Prozessanlage markant reduziert werden. Im Ergebnis reduziert dies die Fertigungskosten, da über einen bestimmten Zeitraum gesehen, für die gleiche zu produzierende Menge an elektronischen Bauteilen weniger Substrate und Transportboxen als bisher in einer Fabrik zeitgleich im Umlauf sind. Die Bearbeitung der einzelnen Substrate erfolgt schneller als bisher. Zudem eröffnet die mit der Erfindung mögliche schnellere Reaktionszeit auf eine Anforderung, bestimmte Substrate, insbesondere Wafer, der Prozeßanlage zuzuführen, auch die Möglichkeit, mit kleineren Losgrößen als bisher zu arbeiten und trotzdem vergleichbare Mengen an prozessierten Substraten zu erzielen.

Zusätzlich kann der Vorteil erreicht werden, auf kostenintensive Speichereinrichtungen für Transportboxen zumindest weitestgehend verzichten zu können. Werden, wie dies in einer bevorzugten Ausführungsform vorgesehen ist, innerhalb eines abschließbaren Gehäuses der Transfervorrichtung, die Substrate eingeführt und dort bei Bedarf auch in einer Speichereinrichtung zwischengespeichert, so kann in einer Fabrikationsanlage mit einer deutlich reduzierten Anzahl von im Umlauf befindlichen Transportboxen zumindest die gleiche Menge an Substraten bearbeitet bzw. genutzt werden.

Zur Erzielung dieser Vorteile kann insbesondere eine bevorzugte Ausführungsform der Transfervorrichtung beitragen, die einen Speicherbereich aufweist, in dem eine Speichereinrichtung zur Zwischenlagerung von Substraten angeordnet ist. Die Speichereinrichtung kann beispielsweise ein herkömmliches starres Magazin oder aber eine Speichereinrichtung zur hochverdichteten Lagerung von Substraten aufweisen, wie sie in der WO 2005006407 A1 und WO 2007006166 A2 (PCT/CH2006/000356) beschrieben ist.

Eine solche Speichereinrichtung kann einzelne Speicherelemente beinhalten, die zur Bildung eines Speicherstapels aufeinander stapelbar sind. Im Stapel sitzen solche Speicherelemente mit ihrem Stapelbereich aufeinander auf und weisen vorzugsweise im Inneren einen Bereich zur Aufnahme von jeweils einem Substrat auf. Der Stapelbereich und der Aufnahmebereich der einzelnen Speicherelemente können in vertikaler Stapelrichtung zueinander versetzt sein. Mit solchen Speicherelementen kann eine hochverdichtete Speicherung von Substraten und gleichzeitig eine von außen nicht ohne zusätzliche Manipulation des Stapels zugängliche und damit gegen mechanische Beschädigung oder Kontamination mit Partikeln geschützte Speicherung der Substrate erzielt werden.

Die erfindungsgemässe Transfervorrichtung weist eine erste Ein-/ Ausgabeschnittstelle auf, an der von einer Uberkopftransportanlage (Overhead Hoist Transport OHT) angelieferte Transportboxen an die Transfervorrichtung übergeben werden, um die Transportboxen noch ausserhalb eines Gehäuses der Transfervorrichtung zu öffnen. Die Substrate werden dann nachfolgend aus einem Magazin der jeweiligen Transportbox entnommen und in die Transfervorrichtung eingeführt. Solche erste Ein-/Ausgabeschnittstellen werden von der Anmelderin in einem anderen technischen Zusammenhang unter der Produktbezeichnung SMIF-Loadport und FOUP-Loadport (für die jeweiligen SMIF- oder FOUP-Transportboxen) angeboten. Die erste Ein-/Ausgabeschnittstelle weist vorzugsweise ein Mittel zum Öffnen und Verschließen des jeweiligen Transportboxentyps auf. Im Bereich dieser ersten Ein-/Ausgabeschnittstellle ist die Transfervorrichtung zur Übergabe von Substraten an eine interne Handhabungseinrichtung, insbesondere an einen Stapelgreifer und/oder Einzelgreifer, ausgeführt.

Vor der eigentlichen ersten Ein-/Ausgabeschnittstelle kann die Transfervorrichtung ausserhalb ihres Gehäuses ein Bewegungselement bzw. einen Transportboxen-Wechsler aufweisen, mit dem eine Transportbox von einer ersten Position, an der sich ein Öffner für die Transportbox befindet, zu einer zweiten Position (Pufferposition) und umgekehrt transportiert werden kann. Das Bewegungselement kann hierzu beispielsweise eine geradlinige oder aber eine Drehbewegung ausführen. Ein solches Austauschverfahren für Transportboxen ermöglicht innerhalb einer bestimmten Zeit eine möglichst hohe Anzahl von Transportboxen abzufertigen, da die erste Ein-/Ausgabeschnittstelle nur solange wie zwingend erforderlich durch eine Transportbox besetzt ist.

In einer weiteren zweckmäßigen Ausgestaltung kann die Transfervorrichtung eine in ihrem Gehäuse angeordnete Handhabungseinrichtung aufweisen, die vorzugsweise zwischen den beiden Ein-/Ausgabeschnittstellen verfahrbar ist.

Weitere bevorzugte Ausgestaltungen der Erfindung ergeben sich aus den Ansprüchen, der Beschreibung und der Zeichnung.

Die Erfindung wird anhand von in den Figuren rein schematisch dargestellten Ausführungsbeispielen näher erläutert, es zeigen:
- Fig.1: eine Seitenansicht auf eine bevorzugte Ausführungsform einer erfindungsgemäßen Transfervorrichtung, die für einen ersten Transportboxentyp ausgebildet ist
- Fig. 2: eine Draufsicht auf eine Transfervorrichtung wie in Fig. 1 gezeigt, die für einen zweiten Transportboxentyp ausgebildet ist;
- Fig.3: eine Schnittdarstellung entlang der Linie A-A durch die Transfervorrichtung von Fig. 1.

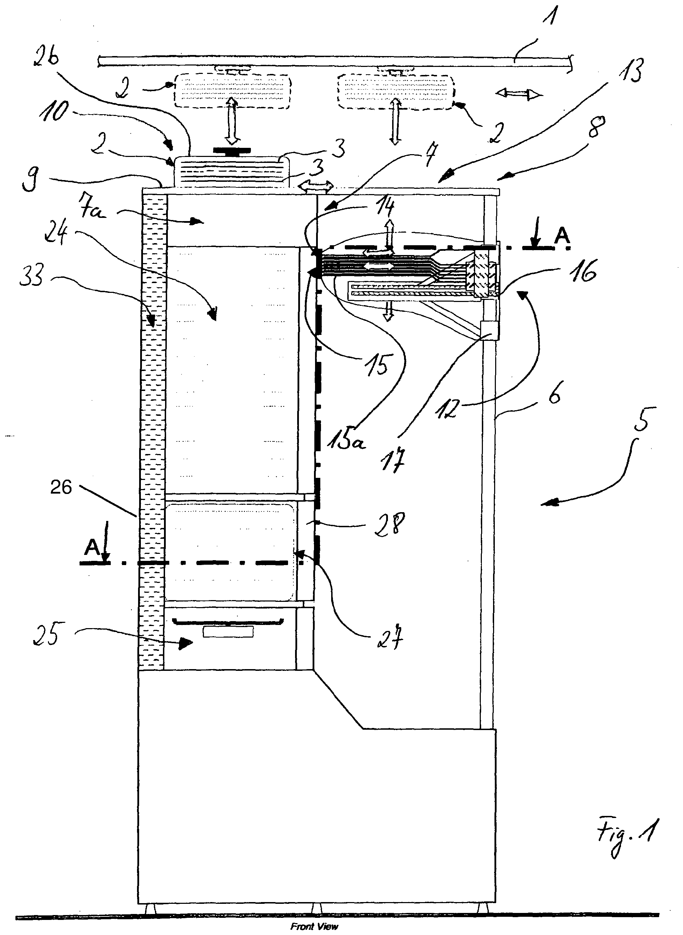

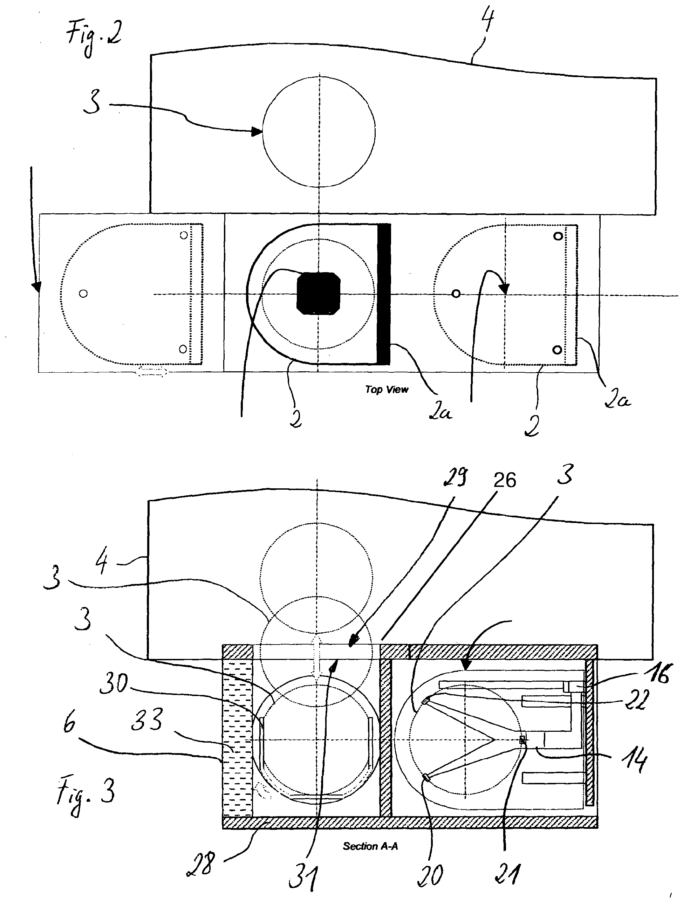

In den Fig.1 bis 3 ist ein Abschnitt einer Überkopf-Transportanlage 1 dargestellt, wie sie in automatisierten Fabrikationsanlagen für die Fertigung von elektronischen Chips häufig Anwendung findet. Mit solchen Überkopf-Transportanlagen 1 werden in genormten Transportboxen 2, wie beispielsweise sogenannten FOUP-Boxen oder SMIF-Boxen, Wafer 3 transportiert, aus denen die elektronischen Bauteilen durch verschiedene Prozessierungen gefertigt werden. Die Wafer 3 müssen hierzu den einzelnen, in der Fabrikationsanlage verteilt angeordneten, Prozessanlagen 4 (Fig. 3) zugeführt werden.

In den Figuren ist zur Zuführung der Wafer zu einer Prozessanlage 4 eine erfindungsgemäße Transfervorrichtung 5 vorgesehen. Die Transfervorrichtung 5 weist im Bereich der Überkopf-Transportanlage 1 an ihrem verschließbaren Gehäuse 6 eine erste Ein-/Ausgabeschnittstelle 7 auf, die zumindest in etwa in der Höhe angeordnet ist, in der Transportboxen von der Überkopf-Transportanlage transportiert und an die Transfervorrichtung 5 angeliefert werden. Um die einzelnen Transportboxen 2 von der Überkopf-Transportanlage 1 zur ersten Ein-/Ausgabeschnittstelle und zurück zu bringen ist ein Transportboxen-Wechsler 8 vorgesehen. Auf einer Plattform 9 des Transportboxen-Wechslers 8 kann von der Überkopf-Transportanlage 1 eine Transportbox auf einer ersten Position 10 abgesetzt und an der ersten Ein-/ Ausgabeschnittstelle 7 befestigt werden. Es ist bevorzugt, wenn die Überkopf-Transportanlage 1 hierzu die jeweilige Transportbox lediglich freigibt und beispielsweise durch lediglich einen Ausklinkvorgang die Transportbox unmittelbar zur ersten Position 10 gelangt. Hierdurch ist insbesondere eine liftlose Übergabe von Transportboxen von der Überkopf-Transportanlage 1 zur Transfervorrichtung 5 und umgekehrt möglich. Je nachdem mit welcher Orientierung die Transportboxen 2 an die Transfervorrichtung 5 angeliefert werden, kann es erforderlich sein, dass der Transportboxen-Wechsler 8 auch mit Mitteln versehen ist, durch die er in der Lage ist die jeweilige Transportbox 2 durch eine Drehbewegung umzuorientieren. Hierdurch können beispielsweise FOUP-Boxen, wie sie in Fig. 2 gezeigt sind, mit ihrem an einer Frontfläche der jeweiligen Transportbox 2 angeordneten verschliessbaren FOUP Door 2a zur ersten Ein-/Ausgabeschnittstelle 7 ausgerichtet werden.

Bei einer SMIF-Box wird mit einer an sich bekannten Einrichtung der Bodenteil zusammen mit dem Magazin der Transportbox 2 und den darin horizontal gelagerten Wafern in das Gehäuse 6 der Transfervorrichtung zu einer Beschickungsposition 7a unmittelbar hinter der Gehäusewand eingeführt.

Die Haube 2b der SMIF-Box verbleibt ausserhalb. Mit einem auf einer Seite der Transfervorrichtung 5 in deren Gehäuse 6 angeordneten und in mehreren Raumrichtungen jeweils linear verfahrbaren Handhabungseinrichtung 12 kann das in den Figuren nicht näher dargestellte Magazin entleert werden. Die Wafer werden innerhalb der Transfervorrichtung 5 in einer nachfolgend noch näher erörterten Weise gehandhabt.

Der Boden der SMIF-Transportbox kann nun mit dem entleerten Magazin wieder aus der Transfervorrichtung 5 ausgeführt und mit der Haube 2b der Transportbox 2 verbunden werden. Die Transportbox 2 ist hierdurch wieder auf der ersten Position 10 des Transportboxen-Wechslers 8 angeordnet. Durch eine Verfahrbewegung des Transportboxen-Wechsler 8 kann die Transportbox 2 zu einer zweiten Position 13 des Wechslers überführt werden, in der sie entweder bis auf weiteres verbleibt, oder aber von der Überkopf-Transportanlage 1 zum Abtransport aufgenommen wird. In der Darstellung von Fig. 1 sind mit gestrichelten Linien zwei Transportboxen 2 gezeigt, von denen sich eine kurz vor der Übergabe an die erste Position 10 und die andere unmittelbar nach der Aufnahme durch die Überkopf-Transportanlage 1 von der zweiten Position 13 befindet. Die genannte Verfahrbewegung(en) des Transportboxen Wechslers 8 kann entweder eine lineare Bewegung oder aber eine Drehbewegung der Plattform 9 sein.

Zur bereits erwähnten Handhabung der Wafer ist innerhalb des Gehäuses 6 der Transfervorrichtung 5 in deren in Fig. 1 rechten Hälfte die Handhabungseinrichtung 12 vorgesehen. Im gezeigten Ausführungsbeispiel weist die Handhabungseinrichtung einen oberen Einzelgreifer (Single-wafer Gripper) 14 sowie einen darunter angeordneten Stapelgreifer (Batchgripper) 15 auf. Der Einzelgreifer 14 und der Stapelgreifer 15 sind auf einem gemeinsamen Schlittenträger 16 angeordnet, der über eine herkömmliche lineare Achse 17 innerhalb des Gehäuses in Z-Richtung verfahrbar ist.

Wie in Fig. 1 und in Fig. 3 zu erkennen ist, kann der Einzelgreifer 14 in an sich vorbekannter Weise ausgebildet sein, beispielsweise als zweiarmiger Greifer, auf dem ein einzelner Wafer 3 in einer Dreipunktauflage 20, 21, 22 angeordnet wird. Der Einzelgreifer kann insbesondere dazu genutzt werden innerhalb der Transfervorrichtung neue Waferstapel zusammenzustellen und/oder einzelne Wafer einer Funktionseinheit der Transfervorrichtung zuzuführen und aus ihr zu entnehmen.

Der Stapelgreifer 15 des gezeigten Ausführungsbeispiels setzt sich aus fünf einzelnen Greifern 15a zusammen, die jeweils zur Aufnahme von nur einem Wafer vorgesehen sind. Die einzelnen Greifer 15a des Stapelgreifers 15 sind in X-Richtung, d.h. in der Darstellung von Fig. 1 in horizontaler Richtung, nur gemeinsam verfahrbar. Die Greifer des Stapelgreifers 15 weisen in vertikaler Richtung einen Abstand zueinander auf, der dem Abstand der Wafer in den Transportboxen bzw. in Magazinen von Transportboxen entspricht. Auch die Greifer 15a des Stapelgreifers 15 können als Greifer mit Dreipunktauflage ausgebildet sein. Im Ausführungsbeispiel weist der Stapelgreifer 15 fünf Greifer 15a auf, die sämtliche Bewegungen ausschliesslich gemeinsam und damit synchron ausführen. In anderen Ausführungsformen der Erfindung kann der Stapelgreifer 15 auch mit einer anderen Anzahl von Greifern 15a versehen sein. Zudem kann auch vorgesehen sein, dass die Greifer 15a unabhängig voneinander betätigbar sind, beispielsweise um Wafer aufzunehmen oder abzusetzen.

Der Stapelgreifer 15 und der Einzelgreifer 14 sind am Schlittenträger 16 jeweils relativ zueinander verfahrbar angeordnet. Bei diesen Verfahrbewegungen handelt es sich um Bewegungen, die für eine Aufnahme von Wafern auf dem jeweiligen Greifer 14, 15, eine Freistellung der aufgenommenen Wafer im Magazin, eine Entnahme aus dem Magazin, eine Transportbewegung in Z-Richtung sowie für ein Absetzen bzw. für eine Übergabe der Wafer erforderlich oder dienlich sind. Bei den Greifern kann es sich somit um passive Greifer handeln, deren Aufnahme- und Absetzbewegung im wesentlichen durch eine Verfahrbewegung des Schlittenträgers 16 erzeugt wird.

In der Darstellung von Fig. 1 links neben der Handhabungseinrichtung 12 und deren schachtartigem vertikalen Verfahrbereich ist eine Speichereinrichtung 24 für eine offene Zwischenlagerung von Wafern außerhalb von Transportboxen oder Magazinen der Transportboxen vorgesehen. Die Speichereinrichtung 24 kann eine Speicherkapazität aufweisen, die ein Vielfaches des Inhalts üblicher Transportboxen für Waferbatches beträgt, beispielsweise für 100 oder 200 Substrate. In einer ersten Variante kann es sich hierbei um eine im wesentlichen starre Speichereinrichtung handeln, die in Art eines herkömmlichen, ortsfesten und in der Transfervorrichtung 5 installierten Magazins aufgebaut ist. Die einzelnen Fächer des Magazins sind für einen Zugriff durch die Greifer 14, 15 zugänglich, wobei der Abstand der Lagerstellen der Fächer für Wafer in Stapelrichtung zumindest im wesentlichen dem Abstand der einzelnen Greifer 15a des Stapelgreifers 15 entspricht.

In einer anderen Variante kann die Speichereinrichtung 24 entweder alleine oder zusätzlich zu einem Magazin der ersten Variante relativ zueinander bewegliche und vorzugsweise direkt aufeinander stapelbare Lagerungselemente aufweisen. Jedes der nicht näher dargestellten Lagerungselemente kann mit einen Lagerungsbereich für die Aufnahme von jeweils einem Wafer versehen sein. Eine solche Speichereinrichtung und deren Mittel zum Öffnen und Verschließen eines Stapels aus Lagerungselementen an vorbestimmbaren Stellen im Stapel ist in der WO 2005006407 A1 und der WO 2007006166 A2 (PCT/CH2006/000356) beschrieben.

In vertikaler Richtung unterhalb der Speichereinrichtung ist ebenfalls innerhalb des Gehäuses 6 eine Einrichtung 25 zur Vorbereitung von Wafern vorgesehen. Es kann sich hierbei insbesondere um eine Markierungs-Erkennungs-Einrichtung (Notch-Finder) handeln, mit der die Detektierung von Markierungen, wie beispielsweise Kerben, am Rand der Wafer zur Bestimmung von deren azimutalen Position möglich ist. Derartige sogenannte Notchaligner erkennen die Kerbe in der Regel mit einem optischen Sensor, wie dies beispielsweise in der US 2002048506A1 beschrieben ist und/oder rasten die Kerbe oder den Wafer-Flat mechanisch an einer Stelle ein, wenn der Wafer gedreht wird. Die letztgenannte Ausführungsform ist beispielsweise in der US 5662452A beschrieben. Beide Verfahren sind grundsätzlich geeignet, um den Wafer anschliessend in eine definierte Winkellage zu bewegen und können zur Ausführung in der als Funktionseinheit ausgebildeten Einrichtung 25 der Transfervorrichtung 5 vorgesehen sein. In anderen Ausführungsformen kann der Aligner auch direkt auf jedem Greifer angeordnet sein, wie dies beispielsweise in der WO 99/57752 und einem entsprechenden Produkt des Unternehmens RECIF, F-31840 Aussonne, beschrieben ist.

Zwischen der Speichereinrichtung 24 und der Vorbereitungseinrichtung befindet sich ein zu einer zweiten Ein-/Ausgabeschnittstelle 26 gehörender Ein-/Ausgabespeicher 27. Dieser kann ein eigenes Gehäuse 28 mit darin befestigten mehreren Speicherplätzen für jeweils einen Wafer bzw. Substrat aufweisen. Im Ausführungsbeispiel sind beispielsweise fünf Speicherplätze 30 vorgesehen. Der Ein-/Ausgabespeicher 27 grenzt direkt an jene Stelle des Gehäuses 6 der Transfervorrichtung 5 an, an der im Gehäuse 6 eine verschließbare Öffnung 29 (Fig. 3) der zweiten Ein-/Ausgabeschnittstelle 26 zum Austausch von Wafern von der Transfervorrichtung zur Prozessanlage 4 bzw. von der Prozessanlage 4 zur Transfervorrichtung 5 vorgesehen ist.

Das Gehäuse des Ein-/Ausgabespeichers 27 weist nur eine Öffnung 31 auf. Das Gehäuse 28 des Ein-/Ausgabespeichers 27 oder aber der gesamte Ein-/Ausgabespeicher 27 können zudem insbesondere um eine vertikale Achse drehbar gestaltet sein. Hierdurch kann in einer ersten Drehposition ein Zugriff von der Handhabungseinrichtung 12 auf den Ein-/Ausgabespeicher 27 möglich sein. In einer zweiten, in Fig. 3 gezeigten, Drehposition kann die Öffnung 31 zur Prozeßanlage 4 gedreht sein, die - bezogen auf den Ein-/Ausgabespeicher - eine Ein-/Ausgabe von Wafern von bzw. zur direkt an die Transfervorrichtung angrenzende Prozessanlage 4 ermöglicht. Sofern der Ein-/Ausgabespeicher mit einem Gehäuse 28 versehen ist, ist es bei einer solchen Ausgestaltung damit möglich, auch mit nur einer Öffnung in dessen Gehäuse 28 auszukommen. Die von der Prozessanlage 4 oder von der Handhabungseinrichtung 12 in den Ein-/Ausgabespeicher 27 eingesetzten Wafer können nach einer Drehbewegung von etwa jeweils 90° nach ihrem Einsetzen von der jeweils anderen Funktionseinheit (Prozeßanlage bzw. Handhabungseinrichtung) entnommen werden.

In einer anderen Ausführungsform des Ein-/Ausgabespeichers ist dessen Gehäuse mit einer zweiten, zur Handhabungseinrichtung 12 weisenden, Öffnung versehen, durch die auch ohne Drehbewegung sowohl von der Prozeßanlage als auch von der Handhabungseinrichtung 12 Wafer in den Ein-/Ausgabespeicher 27 eingesetzt und entnommen werden können. Ferner können auch Ausführungsformen vorgesehen sein, deren Ein-/Ausgabespeicher 27 ohne Gehäuse auskommen.

In bevorzugten Weiterbildung kann der Ein-/Ausgabespeicher 27 auch zweigeteilt sein und zwei voneinander unabhängige Teil-Ein-/Ausgabespeicher aufweisen. Hierbei kann jeweils einer der Teil-Ein-/Ausgabespeicher zur Aufnahme von Wafern aus der Prozessanlage 4 und der andere Teil-Ein-/Ausgabespeicher zur Bereitstellung von Wafern für eine Übergabe an die Prozeßanlage dienen.

Zur Erzeugung von Reinraumbedingungen in dem verschließbaren Gehäuse 6 der Transfervorrichtung kann an einer Seite des Gehäuses ein vertikaler Kanal 33 zur Zuführung von Reinluft oder Stickstoff vorgesehen sein, der gegebenenfalls auch mittels Strömungsleitelementen in einer vorbestimmten Weise durch die Transfervorrichtung 5 strömt.

Mit der erfindungsgemässen Transfervorrichtung ist es erstmals möglich Wafer direkt von einer Überkopf-Transportanlage ohne Transportbox in eine Transfervorrichtung einzuführen und aufzunehmen, unter Reinraumbedingungen offen zwischenzuspeichern und direkt, d.h. ohne eine Anordnung in einer Transportbox, an eine Prozeßanlage zu übergeben. Zudem ist es mit der Transfervorrichtung auch möglich, Wafer direkt von der einen Ein-/Ausgabeschnittstelle zu der sich in vertikaler Richtung an einer anderen Stelle des Gehäuses 6 befindenden jeweils anderen Ein-/Ausgabeschnittstelle durch die Transfervorrichtung zu befördern, um einzelne Wafer oder ein Stapel von Wafern ohne Zwischenspeicherung im Gehäuse 6 von der Überkopf-Transportanlage 1 der Prozessanlage 4 zuzuführen oder umgekehrt.

Schliesslich kann eine an der ersten Ein-/Ausgabeschnittstelle 7 angeordnete geöffnete Transportbox nach einer Entnahme von (unprozessierten) Wafern 3 durch die Handhabungseinrichtung 12 auch sofort wieder mit anderen (prozessierten) Wafern 3 beschickt werden, ohne dass die Transportbox zwischenzeitlich von der ersten Ein-/Ausgabeschnittstelle 7 entfernt bzw. geschlossen wird. Hierzu kann die Handhabungseinrichtung 12 die eingeführten Wafer an einer vorgesehen Stelle, beispielsweise in der Speichereinrichtung 24, absetzen, danach die anderen Wafer aufnehmen und diese in die Transportbox einsetzen. Letztere wird anschliessend verschlossen und steht dann zum Abtransport durch die Überkopf-Transportanlage bereit. Mit einem solchen Ablauf lassen sich besonders kurze Verweilzeiten von Wafern in der Transfervorrichtung erreichen sowie die Anzahl von leer zu transportierenden bzw. leer zwischenzuspeichernden Transportboxen reduzieren. Dieser Vorteil lässt sich nochmals dadurch steigern, dass eine Handhabungseinrichtung 12 verwendet wird, die in der Lage ist zwei Waferstapel gleichzeitig aufzunehmen und hierzu insbesondere zwei Stapelgreifer aufweist. Hierbei kann die Handhabungseinrichtung 12 mit einem Stapel prozessierter Wafer zur ersten Ein-/Ausgabeschnittstelle 7 verfahren, dort einen Stapel (unprozessierter) Wafer aus der Transportbox entnehmen und unmittelbar anschliessend den Stapel (prozessierter) Wafer in die Transportbox einsetzen. Erst danach werden die unprozessierten Wafer durch die Handhabungseinrichtung an eine geeignete Stelle der Transfervorrichtung übergeben. Der gleiche Vorteil wie bei Waferstapeln lässt sich auch bei Transportboxen mit nur einem Speicherplatz erreichen, wenn die Handhabungseinrichtung mit zwei Einzelgreifern versehen ist.

Bevorzugte Ausführungsformen der Erfindung haben den Vorteil, dass mit ihnen zudem in einer solchen Transfervorrichtung auch unter Zuhilfenahme von einem und/oder beiden Greifern 14, 15 neue Waferstapel zusammengestellt werden können. Zudem können die zur Ausgabe vorgesehenen Wafer mittels der Vorbereitungseinrichtung in eine vorbestimmte Rotationsposition gebracht werden. In einer nicht näher gezeigten Ausführungsform kann die Vorbereitungseinrichtung der Transfervorrichtung auch eine Partikeldetektionseinrichtung aufweisen, mit der Verschmutzungen der Substrate detektiert und gegebenenfalls entfernt werden.

**Bezugszeichenliste**

| | | | |
|---|---|---|---|
| 1 | Überkopf-Transportanlage | 22 | dritte Dreipunktauflage |
| 2 | Transportbox | 24 | Speichereinrichtung |
| 2a | FOUP Door | 25 | Einrichtung |
| | | | |
| 2b | Haube | | |
| 3 | Wafer | 26 | zweite Ein-/Ausgabeschnittstelle |
| 4 | Prozessanlage | 27 | Ein-/Ausgabespeicher |
| 5 | Transfervorrichtung | 28 | Gehäuse |
| 6 | Gehäuse | 29 | verschliessbare Öffnung |
| 7 | erste Ein-/Ausgabeschnittstelle | 30 | Speicherplatz |
| 7a | Beschickungsposition | 31 | Öffnung |
| 8 | Transportboxen-Wechsler | | |
| 9 | Plattform | 33 | vertikaler Kanal |
| | | | |
| 10 | erste Position | | |
| 12 | Handhabungseinrichtung | | |
| 13 | zweite Position | | |
| 14 | Einzelgreifer | | |
| 15 | Stapelgreifer | | |
| 15a | Greifer | | |
| 16 | Schlittenträger | | |
| 17 | lineare Achse | 20 | erste Dreipunktauflage |
| 21 | zweite Dreipunktauflage | | |

## Patentansprüche

1. Transfervorrichtung (5) für Substrate aus dem Bereich der Fertigung von elektronischen Bauteilen oder Displays, die zur Zuführung von Substraten zu einer Prozessanlage (4) vorgesehen ist, wobei die Transfervorrichtung (5) mit einem Gehäuse (6) versehen ist, das eine erste Ein-/Ausgabeschnittstelle (7) zu einer Überkopf-Transportanlage (1) für Substrat-Transportboxen aufweist **dadurch gekennzeichnet, dass** das Gehäuse (6) weiterhin eine zweite Ein-/Ausgabeschnittstelle (26) zur Prozessanlage (4) aufweist, wobei die erste Ein-/ Ausgabeschnittstelle (7) in Bezug auf eine vertikale Richtung oberhalb der zweiten Ein-/Ausgabeschnittstelle (26) angeordnet ist, und dass die Transfervorrichtung (5) weiterhin eine in der Transfervorrichtung (5) angeordnete Handhabungseinrichtung (12), mit der die Substrate aus den Transportboxen (2) entnehmbar sind und frei von Transportboxen (2) in die Transfervorrichtung (5) einführbar sind, sowie Mittel, mit denen die Substrate durch die in der Transfervorrichtung (5) angeordnete Handhabungseinrichtung (12) frei von Transportboxen (2) von der einen zur anderen Schnittstelle transportierbar sind, aufweist.

2. Transfervorrichtung (5) nach Anspruch 1, mit einer in der Transfervorrichtung (5) angeordneten Speichereinrichtung (24) mit Speicherplätzen (30) zur Zwischenspeicherung von Substraten.

3. Transfervorrichtung (5) nach Anspruch 2, wobei die Speichereinrichtung (24) innerhalb des Gehäuses (6) angeordnet ist, und die Speichereinrichtung (24) aufeinander stapelbare und relativ zueinander bewegliche Speicherelemente zur Aufnahme von jeweils einem Substrat aufweist.

4. Transfervorrichtung (5) nach zumindest einem der vorhergehenden Ansprüche mit Mitteln zur Zusammenstellung eines Substratstapels innerhalb des Gehäuses (6).

5. Transfervorrichtung (5) nach zumindest einem der vorhergehenden Ansprüche mit Mitteln zur Detektion der azimutalen Position von Substraten sowie Mitteln zur Veränderung der azimutalen Position.

6. Transfervorrichtung (5) nach zumindest einem der vorhergehenden Ansprüche wobei mit der in der Transfervorrichtung (5) angeordneten Handhabungseinrichtung (12) Substrate zur Übergabe an die Prozessanlage (4) bereitstellbar sind.

7. Transfervorrichtung (5) nach zumindest einem der vorhergehenden Ansprüche wobei die Handhabungseinrichtung (12) sowohl einen Stapelgreifer (15) als auch zumindest einen Einzelgreifer (14) aufweist.

8. Transfervorrichtung (5) nach zumindest einem der vorhergehenden Ansprüche mit einem Ein-/Ausgabespeicher (27) als Bestandteil der zweiten Ein-/Ausgabeschnittstelle (26), in der Substrate für einen Austausch mit der Prozessanlage (4) absetzbar und entnehmbar sind.

9. Transfervorrichtung (5) nach Anspruch 8, mit Bewegungsmitteln des Ein-/Ausgabespeichers (27), insbesondere Bewegungsmittel zur Erzeugung einer Drehbewegung.

10. Transfervorrichtung (5) nach zumindest einem der vorhergehenden Ansprüche mit einem Transportboxen-Wechsler (8), mit dem vor oder auf dem Gehäuse (6) der Transfervorrichtung (5) angeordnete Transportboxen (2) von einer Ladeposition zu einer Pufferposition und umgekehrt überführbar sind.

11. Transfervorrichtung (5) nach zumindest einem der vorhergehenden Ansprüche mit Mitteln zur Erzeugung von Reinraumbedingungen innerhalb des Gehäuses (6) der Transfervorrichtung (5).

12. Verfahren zur Zuführung von zumindest einem Substrat zu einer Prozessanlage (4), wobei das in einer Transportbox (2) angeordnete zumindest eine Substrat von einer Überkopf-Transportanlage (1) an einer ersten Ein-/Ausgabeschnittstelle (7) einer vor der Prozessanlage (4) angeordneten Transfervorrichtung (5) bereitgestellt wird, **dadurch gekennzeichnet, dass** das zumindest eine Substrat im Bereich der ersten Ein-/Ausgabeschnittstelle (7) aus der Transportbox (2) entnommen, ohne Transportbox (2) in ein Gehäuse (6) der Transfervorrichtung (5) eingeführt wird, und nachfolgend zu einer zweiten Ein-/Ausgabeschnittstelle (26) der Transfervorrichtung (5) überführt und dort für die Prozessanlage (4) bereitgestellt wird, wobei die erste Ein-/Ausgabeschnittstelle (7) in Bezug auf eine vertikale Richtung oberhalb der zweiten Ein-/Ausgabeschnittstelle (26) angeordnet ist.

13. Verfahren nach Anspruch 12, wobei Substrate innerhalb des Gehäuses (6) der Transfervorrichtung (5) offen zwischengelagert werden.

14. Verfahren nach zumindest einem der vorhergehenden Ansprüche 12 oder 13, wobei in der Transfervorrichtung (5) eine Ausrichtung von Substraten in eine Rotations-Sollposition erfolgt.

15. Verfahren nach zumindest einem der vorhergehenden Ansprüche 12 bis 14, wobei innerhalb des Gehäuses (6) der Transfervorrichtung (5) zumindest ein Substrat in einen Ein-/Ausgabespeicher (27) der zweiten Ein-/Ausgabeschnittstelle (26) angeordnet wird.

## Claims

1. Transfer device (5) for substrates from the field of manufacturing of electronic components or displays, which is provided for feeding substrates to a process plant (4), said transfer device (5) being provided with a housing (6) having a first input/output interface (7) to an overhead transport plant (1) for substrate transport boxes (2)
**characterized in that** the housing (6) has a second input/output interface (26) to the process plant (4), the first input/output interface (7) being arranged above the second input/output interface (26) with respect to a vertical direction, and **in that** the transfer device (5) further comprises a handling device (12) which is arranged in the transfer device (5) and by means of which the substrates can be removed from the transport boxes (2) and can be introduced into the transfer device (5) free of transport boxes (2), as well as
means with which the substrates can be transported from one interface (7) to the other interface (26) by the handling device (12) arranged in the transfer device (5) free of transport boxes (2).

2. Transfer device (5) according to claim 1, with a storage device (24) arranged in the transfer device (5) with storage locations (30) for intermediate storage of substrates.

3. The transfer device (5) according to claim 2, wherein the storage device (24) is arranged within the housing (6), and the storage device (24) comprises storage elements stackable on top of each other and movable relative to each other for receiving one substrate each.

4. Transfer device (5) according to at least one of the preceding claims, comprising means for assembling a substrate stack within the housing (6).

5. Transfer device (5) according to at least one of the preceding claims, comprising means for detecting the azimuthal position of substrates means for changing the azimuthal position.

6. Transfer device (5) according to at least one of the preceding claims, wherein substrates can be made available for transfer to the process plant (4) by means of the handling device (12) arranged in the transfer device (5).

7. Transfer device (5) according to at least one of the preceding claims, wherein the handling device (12) comprises both a stack gripper (15) and at least one single gripper (14).

8. Transfer device (5) according to at least one of the preceding claims, having an input/output store (27) as part of the second input/output interface (26), in which substrates can be deposited and removed for exchange with the process system (4).

9. Transfer device (5) according to claim 8, with movement means of the input/output store (27), in particular movement means for generating a rotary movement.

10. Transfer device (5) according to at least one of the preceding claims, having a transport box changer (8) with which transport boxes (2) arranged in front of or on the housing (6) of the transfer device (5) can be transferred from a loading position to a buffer position and vice versa.

11. Transfer device (5) according to at least one of the preceding claims, **characterized by** means for creating clean room conditions within the housing (6) of the transfer device (5).

12. Method for feeding at least one substrate to a process plant, the at least one substrate arranged in a transport box (2) being provided by an overhead transport plant (1) at a first input/output interface (7) of a transfer device (5) arranged upstream of the process plant (4), **characterized in that** the at least one substrate is removed from the transport box in the region of the first input/output interface (7), is introduced without the transport box (2) into a housing (6) of the transfer device (5), and is subsequently transferred to a second input/output interface (26) of the transfer device (5) and is made available there for the process system (4), the first interface (7) being arranged above the second interface (26) with respect to a vertical direction.

13. The method of claim 12, wherein substrates are openly temporarily stored within a housing (6) of the transfer device.

14. Method according to at least one of the preceding claims 12 or 13, wherein in the transfer device (5) an alignment of substrates into a rotation set position takes place.

15. Method according to at least one of the preceding claims 12 to 14, wherein within the housing (6) of the transfer device (5) at least one substrate is arranged in an input/output memory (27) of the second input/output interface (26).

## Revendications

1. Dispositif de transfert (5) pour des substrats du domaine de la fabrication de composants électroniques ou d'affichages, qui est prévu pour amener des substrats à une installation de traitement (4), le dispositif de transfert (5) étant pourvu d'un boîtier (6) qui présente une première interface d'entrée/sortie (7) vers une installation de transport aérienne (1) pour des boîtes de transport de substrat (2),
**caractérisé en ce que** le boîtier (6) présente une deuxième interface d'entrée/sortie (26) vers l'installation de traitement (4), la première interface d'entrée/sortie (7) étant disposée au-dessus de la deuxième interface d'entrée/sortie (26) par rapport à une direction verticale, et **en ce que** le dispositif de transfert (5) présente en outre un dispositif de manipulation (12) disposé dans le dispositif de transfert (5), avec lequel les substrats peuvent être retirés des boîtes de transport (2) et peuvent être introduits dans le dispositif de transfert (5) sans boîtes de transport (2), ainsi que des moyens de commande (14) disposés dans le boîtier (6).
des moyens avec lesquels les substrats peuvent être transportés d'une interface (7, 26) à l'autre par le dispositif de manipulation (12) disposé dans le dispositif de transfert (5), sans boîtes de transport (2).

2. Dispositif de transfert (5) selon la revendication 1, avec un dispositif de stockage (24) disposé dans le dispositif de transfert (5) avec des emplacements de stockage (30) pour le stockage intermédiaire de substrats.

3. Dispositif de transfert (5) selon la revendication 2, dans lequel le dispositif de stockage (24) est disposé à l'intérieur du bo tier (6), et le dispositif de stockage (24) présente des éléments de stockage empilables les uns sur les autres et mobiles les uns par rapport aux autres pour recevoir chacun un substrat.

4. Dispositif de transfert (5) selon au moins l'une des revendications précédentes, comprenant des moyens pour assembler une pile de substrats à l'intérieur du boîtier (6).

5. Dispositif de transfert (5) selon au moins l'une des revendications précédentes, comprenant des moyens de détection de la position azimutale de substrats des moyens de modification de la position azimutale.

6. Dispositif de transfert (5) selon au moins l'une des revendications précédentes, dans lequel le dispositif de manipulation (12) disposé dans le dispositif de transfert (5) permet de mettre à disposition des substrats pour les transférer à l'installation de traitement (4).

7. Dispositif de transfert (5) selon au moins l'une des revendications précédentes, dans lequel le dispositif de manipulation (12) comporte à la fois une pince d'empilage (15) et au moins une pince individuelle (14).

8. Dispositif de transfert (5) selon au moins l'une des revendications précédentes, avec une mémoire d'entrée/sortie (27) faisant partie de la deuxième interface d'entrée/sortie (26), dans laquelle des substrats peuvent être déposés et retirés pour un échange avec l'installation de traitement (4).

9. Dispositif de transfert (5) selon la revendication 8, comprenant des moyens de déplacement de la mémoire d'entrée/sortie (27), notamment des moyens de déplacement pour générer un mouvement de rotation.

10. Dispositif de transfert (5) selon au moins l'une des revendications précédentes, avec un changeur de boîtes de transport (8), avec lequel des boîtes de transport (2) disposées devant ou sur le boîtier (6) du dispositif de transfert (5) peuvent être transférées d'une position de chargement à une position tampon et inversement.

11. Dispositif de transfert (5) selon au moins l'une des revendications précédentes, **caractérisé par** des moyens pour créer des conditions de salle blanche à l'intérieur du boîtier (6) du dispositif de transfert (5).

12. Procédé pour amener au moins un substrat à une installation de traitement, le au moins un substrat disposé dans une boîte de transport (2) étant mis à disposition par une installation de transport aérienne (1) au niveau d'une première interface d'entrée/sortie (7) disposée en amont de l'installation de traitement (4), **caractérisé en ce que** le au moins un substrat est prélevé dans la zone de la première interface d'entrée/sortie (7) de la boîte de transport, sans boîte de transport (2), est introduit dans un boîtier (6) du dispositif de transfert (5), et est ensuite transféré vers une deuxième interface d'entrée/sortie (26) du dispositif de transfert (5) et y est mis à disposition pour l'installation de traitement (4), la première interface (7) étant disposée au-dessus de la deuxième interface (26) par rapport à une direction verticale.

13. Procédé selon la revendication 12, dans lequel des substrats sont stockés temporairement de manière ouverte à l'intérieur d'un logement (6) du dispositif de transfert.

14. Procédé selon au moins l'une des revendications 12 ou 13 précédentes, dans lequel on effectue dans le dispositif de transfert (5) un alignement de substrats dans une position de consigne de rotation.

15. Procédé selon au moins l'une des revendications précédentes 12 à 14, dans lequel on dispose à l'intérieur du boîtier (6) du dispositif de transfert (5) au moins un substrat dans une mémoire d'entrée/sortie (27) de la deuxième interface d'entrée/sortie (26).
